# EUROPÄISCHE PATENTSCHRIFT

(11) **EP 3 306 295 B1**
(45) Veröffentlichungstag und Bekanntmachung des Hinweises auf die Patenterteilung: **26.06.2019**
(21) Anmeldenummer: 17195248.4
(22) Anmeldetag: 06.10.2017
(51) Int. Cl.: G01M 17/00

(54) **VERFAHREN UND VORRICHTUNG ZUM TESTEN ELEKTRONISCHER STEUERUNGEN, INSBESONDERE ZUM TESTEN VON AUTOMOBILSTEUERUNGEN**
METHOD AND DEVICE FOR TESTING ELECTRONIC CONTROLS, IN PARTICULAR FOR TESTING OF AUTOMOBILE CONTROL SYSTEMS
PROCÉDÉ ET DISPOSITIF D'ESSAI DE COMMANDES ÉLECTRONIQUES, EN PARTICULIER D'ESSAI DE COMMANDES AUTOMOBILES

(30) Priorität: 07.10.2016 DE 102016219550
(43) Veröffentlichungstag der Anmeldung: 11.04.2018
(73) Patentinhaber: Ford Global Technologies, LLC, Dearborn, MI 48126 (US)
(72) Erfinder: Busch, Rainer, 52076 Aachen (DE); Rambow, Thomas, 52070 Aachen (DE); Hansen, Norman, 4701 Kettenis (BE); Wiechowski, Norbert, 52070 Aachen (DE); Kugler, Alexander, 52074 Aachen (DE); Kowalewski, Stefan, 52159 Roetgen (DE)
(74) Vertreter: Dörfler, Thomas

(56) Entgegenhaltungen:
- EP-A1- 3 035 281
- WO-A2-2008/037656
- US-B1- 6 421 823
- US-B1- 6 539 534

## Beschreibung

Die Erfindung betrifft ein Verfahren und eine Vorrichtung zum Testen elektronischer Steuerungen, insbesondere Automobilsteuerungen.

Insbesondere betrifft die Erfindung ein Verfahren und eine Vorrichtung zum Testen eines Programms zur Echtzeit-Signalverarbeitung, insbesondere für Steuerapplikationen in Automobilen.

Im Automobilbereich werden eingebettete Softwareanwendungen häufig als Funktion bzw. auf Basis von physikalischen und logischen Signalwerten entwickelt, beispielsweise Gaspedalpositionen und anderen Informationssignalen. Zum Testen der jeweiligen Softwareanwendungen ist es dann erforderlich, aussagekräftige Sequenzen für diese Signale zu definieren, die Softwareanwendung unter Verwendung der betreffenden Signale auszuführen und die erzeugten Ausgangswerte zu evaluieren bzw. zu bewerten.

Ein beispielhaftes Szenario kann etwa so beschaffen sein, dass ein Fahrzeug durch Betätigung des Gaspedals auf eine vorgegebene Geschwindigkeit beschleunigt werden soll und nach Erreichen dieser Geschwindigkeit das Gaspedal losgelassen wird. Hierbei kann ein Simulationsmodell zur Beschreibung des Fahrzeugs mit entsprechenden Schnittstellen zur Beeinflussung des Gaspedals verwendet werden.

Ein in der Praxis auftretendes Problem ist, dass die Spezifizierung von Signalen, welche den in der realen Welt tatsächlich auftretenden Signalen ähnlich sein sollen, zeitaufwendig und fehlerbehaftet ist. Folglich wird dieser Schritt häufig solange vernachlässigt, bis die Softwareanwendung in die eingebettete Hardware integriert wird. Darüber hinaus ist eine Reaktion auf die während der Ausführung der betreffenden Softwareanwendung berechneten Signale sowie deren Änderung nicht möglich, ohne eine Änderung der Softwareanwendung selbst vorzunehmen, was wiederum unerwünschte Nebeneffekte zur Folge haben kann, wenn die betreffenden Änderungen nicht vor der betreffenden Code-Erzeugung wieder beseitigt werden.

Aus der DE 103 03 489 A1 ist ein Verfahren zum Testen von Software für eine Fahrzeugsteuereinheit in Echtzeit bekannt.

Zum weiteren Stand der Technik wird lediglich beispielhaft auf die US 6 421 823 B1, WO 2008/037656 A2, US 7 523 441 B2,

EP 1 898 282 A1 und die US 6 539 534 B1 verwiesen.

Es ist eine Aufgabe der vorliegenden Erfindung, ein Verfahren und eine Vorrichtung zum Testen elektronischer Steuerungen, insbesondere Automobilsteuerungen, bereitzustellen, welche bei möglichst weitgehender Automatisierung den Einsatz schon während des Entwicklungsprozesses ermöglichen.

Diese Aufgabe wird durch das Verfahren gemäß den Merkmalen des unabhängigen Patentanspruchs 1 bzw. die Vorrichtung gemäß den Merkmalen des nebengeordneten Patentanspruchs 4 gelöst.

Bei einem erfindungsgemäßen Verfahren zum Testen elektronischer Steuerungen, insbesondere zum Testen von Automobilsteuerungen, wobei in einem Simulationsprozess ein vorgegebenes Szenario auf einer Testplattform in einem Testszenario simuliert wird und wobei die Testplattform in diesem Simulationsprozess auf Basis von Eingangs-Stimuli Ausgangswerte erzeugt, erfolgt eine dynamische Anpassung des Testszenarios während des Simulationsprozesses auf Basis des aktuellen Zustandes des Simulationsprozesses.

Dazu wird die Ausführung des Softwareprogramms bzw. des Simulationsprozesses unterbrochen, es erfolgt eine Kommunikation mit der Testplattform, die Eingangs-Stimuli werden neu berechnet, die Eingangs-Stimuli werden dann an die Testplattform gesendet und es erfolgt ein Umschalten auf die neu berechneten Eingangs-Stimuli, bevor die Simulation fortgesetzt wird.

Das erfindungsgemäße Verfahren ermöglicht es insbesondere, während eines Simulationsprozesses mit der jeweiligen Testplattform zu interagieren bzw. mit dieser in Datenaustausch zu treten und dabei auf Ereignisse während der Simulation zu reagieren. Dabei können Stimulationssignale des jeweiligen Szenarios geändert werden und auch Werte, die von der Testplattform selbst während der Simulation erzeugt wurden, überschrieben werden, sofern dies in dem betreffenden Szenario spezifiziert und gewünscht ist.

Bei der automatisierten Änderung der Stimulationssignale ("Stimuli") werden sowohl der aktuelle Zustand der Simulation als auch die bis zu dem jeweiligen Zeitpunkt von der Testplattform erzeugten Ausgangswerte berücksichtigt und basierend hierauf neue Stimuli sowie Ausgangswerte für die aktuell laufende Simulation erzeugt. Von diesen Stimuli sind sowohl solche, welche die Eingänge des zu testenden Systems direkt ansprechen, als auch Signalwerte, die innerhalb des zu testenden Systems von der Testplattform generiert werden, umfasst. Dabei wird insgesamt ein vollständig automatisierter Testprozess realisiert.

Das erfindungsgemäße Verfahren ermöglicht es, den aktuellen Systemzustand zu einem vorgegebenen Zeitpunkt oder in Abhängigkeit von während der Simulation auftretenden Ereignissen zu berücksichtigen und entsprechende, diesen Systemzustand beschreibende Werte dazu zu nutzen, die Stimulationssignale ("Stimuli") und Referenzwerte dynamisch anzupassen.

Hierzu wird der normale Ablauf des Programms unterbrochen, wozu entsprechende programminterne Zeitgeber, die die Ausführungszeit innerhalb des Programms angeben, temporär angehalten werden, und es erfolgt die Neuberechnung und das Umschalten auf neue Eingangs-Stimuli, woraufhin die Simulation - und damit auch die programminterne Zeitgebung - wieder fortgesetzt wird.

Durch die Erfindung wird insgesamt ein effizientes Verfahren zum Testen eines Simulationsprozesses bereitgestellt, welches in einfacher Weise die Spezifizierung von Signalen sowie Akzeptanz- bzw. Toleranzkriterien unter gleichzeitiger Verwendbarkeit interner (d.h. während der Programmausführung erzeugter bzw. berechneter) Signale ermöglicht, wobei im Ergebnis eine Automatisierung des betreffenden Prozesses und dessen Einsatz während des Entwicklungsprozesses ermöglicht werden.

Die Erfindung beinhaltet weiter die Bereitstellung einer domänenspezifischen Sprache zur Beschreibung von Signalen, welche der natürlichen Sprache ähnelt, so dass beliebige komplexe Signale unabhängig von der jeweiligen Plattform der Programmausführung beschrieben werden können. Die erfindungsgemäße Implementierung bündelt hierbei die Funktionalitäten der Analyse der Plattform zur Programmausführung, die Bereitstellung einer Eingabemöglichkeit zur Signalspezifizierung und die Automatisierung des gesamten Prozesses aus Eingabe von Stimulationssignalen, Ausführung und Evaluierung. Ein Vorteil dieser Herangehensweise ist, dass die entsprechenden Signalspezifikationen universell für unterschiedliche Softwareumgebungen und Programmiersprachen (Assembler, Zwischencode, Hochsprache) generiert und vorgehalten werden können.

Ein wesentlicher Vorteil des erfindungsgemäßen Verfahrens ist dabei die Ausnutzung interner Signale einer Software (d.h. die Nutzung von Signalen, die während der Softwareausführung berechnet worden sind) und die Verwendbarkeit dieser Signale zur Reaktion auf zuvor spezifizierte Bedingungen bzw. Zustände ("reaktives Testen") zur Änderung der Eingangs-Stimulationssignale während der Simulation auf Basis dieser Bedingungen bzw. Zustände. Darüber hinaus können die entsprechenden Werte zur Neuberechnung der Stimulationswerte sowie der Akzeptanz- bzw. Toleranzkriterien verwendet werden. Dies kann dadurch erreicht werden, dass die Ausführung der Softwareanwendung unterbrochen wird, eine Kommunikation mit der erfindungsgemäßen Vorrichtung - also auf einer Metaebene - erfolgt, die Signale neu berechnet werden, die Signale dann an die Plattform zur Softwareausführung gesendet werden und ein Umschalten auf die neu berechneten Signale erfolgt, bevor die Simulation fortgesetzt wird.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

Es zeigen:
- Figur 1: ein Flussdiagramm zur Erläuterung des möglichen Ablaufs eines erfindungsgemäßen Verfahrens in einer Ausführungsform; und
- Figur 2: ein Blockdiagramm zur weiteren Erläuterung der Erfindung.

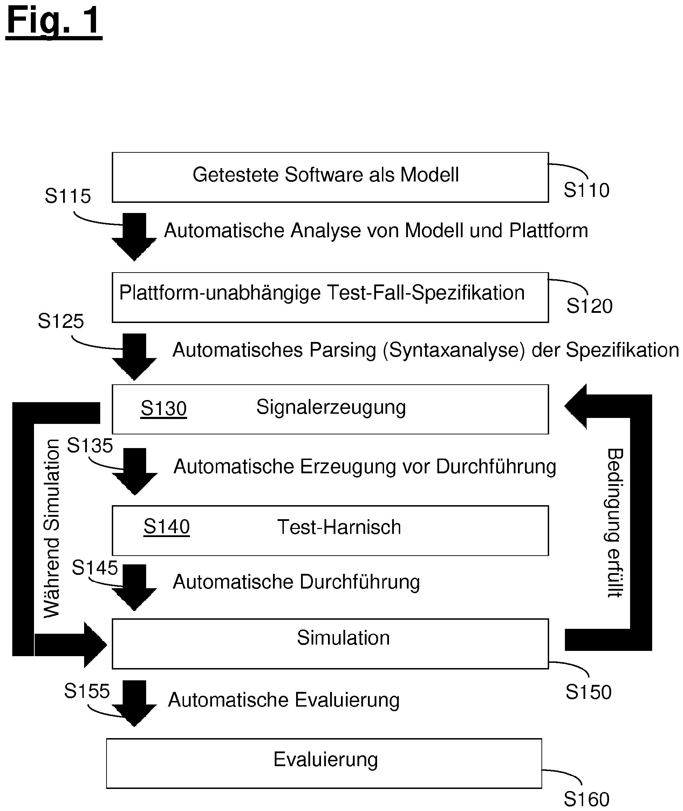

Fig. 1 zeigt ein Flussdiagramm zur Erläuterung des möglichen Ablaufs eines erfindungsgemäßen Verfahrens in einer Ausführungsform.

Zum Testen eines Steuerungsprogramms müssen Signale beschrieben werden, welche dazu verwendet werden, die Eingaben des Programms während der Durchführung zu stimulieren. Während der Simulation werden die entsprechenden Ausgangssignale aufgezeichnet und evaluiert, indem die aufgezeichneten Werte mit zuvor spezifizierten Akzeptanz- bzw. Toleranzkriterien verglichen werden.

Die Test-Fall-Spezifikation (S120) wird einem Parsing bzw. einer Syntax- und Semantikanalyse unterzogen und zu Signalen kompiliert (S125). Zunächst werden gemäß Fig. 1 das im Test befindliche Steuerungsprogramm (S110) und die Ausführungsplattform analysiert, um die Schnittstelle des Programms zu identifizieren und plattformspezifische Variablen zu nutzen (S115). Basierend auf der Schnittstelle wird automatisch ein sog. Test-Harnisch (S140) erzeugt (S135). Dieser Test-Harnisch stellt eine Kopie des ursprünglichen Programms, ergänzt bzw. angereichert durch spezifische Elemente dar, welche die Eingabestimulation, die Aufzeichnung der Ausgangswerte und die Manipulation der internen Signale ermöglichen. Darauf basierend wird der Test automatisch durchgeführt (S145, S150). Sobald entsprechende Bedingungen erfüllt sind, wird die Ausführung unterbrochen, und der aktuelle Status der Programmvariablen wird an die erfindungsgemäße Vorrichtung (d.h. die in dem Testharnisch integrierten Metafunktionen zur Steuerung des Testablaufs) gesendet, die Signale werden basierend auf dem Status der Programmvariablen neu erzeugt und zurück an die Ausführungsplattform gesendet. Somit weist der Test-Harnisch während des Testlaufs einen dynamischen Charakter auf.

Nachdem der Testlauf beendet ist wird überprüft, ob die Akzeptanz-Kriterien erfüllt sind und die aufgezeichneten Ausgangswerte werden automatisch evaluiert, d.h., es werden vorgegebene Parameter und Qualitätskriterien ausgegeben und gespeichert (S155, S160).

In einer beispielhaften Implementierung kann eine Test-Spezifikation folgende Parameter umfassen:
*Eingänge:*
   *<eingangssgnal1> [0]*
*Ausgänge:*
   *<ausgangssgnal1> [0] (EIN;-0.1;0.1;1;.5;0.1;0.001;0)*
   *Kalibrierung 1:*
   *Kalibrierung 2:*
*Konstanten:*
*Kontinuierliche Signaländerungen:*
*Test:*
   *Schritt 1:*
   *Schritt 2:*
*Akzeptanz:*
   *Kriterium 1:*
   *Kriterium 2:*

Der Abschnitt "Eingänge" beschreibt die grundsätzlichen Attribute der Stimuli für jeden Eingang. Der Abschnitt "Ausgang" beschreibt Referenzsignale inklusive der Attribute für die Evaluation. Die "Kalibrierungen" beschreiben eine Änderung eines lokalen Parameters während des Tests, erlauben somit die bequeme Durchführung des Tests mit unterschiedlichen Parametern. Wenn beispielsweise zwei Kalibrierbare angegeben werden, resultieren daraus zwei Simulationen mit jeweils veränderten Parametern.

Die vorzugebenden Eingangssignale werden in dem "Schritt"-Abschnitt beschrieben. Jedem "Schritt"-Abschnitt ist ein "Kriterium" zugeordnet. Die Bedingungen des Kriteriums werden überprüft, solange der entsprechende "Schritt" andauert. Es stehen vielfältige Aktionsbefehle zur Beeinflussung der Signalwerte und deren zeitlicher Entwicklung zur Verfügung, z.B.:
*<signal1> Rampe bis [5.0] in {2.0} Sekunden*
*<signal2> setze auf [WAHR]*
*warte {8.0} Sekunden*

Ein derartiger Testfall wird geparst und in entsprechende Befehle zur Erzeugung bzw. Simulation der Signalwerte in des zu prüfenden Steuerungsprogramms kompiliert. Dabei wird zunächst das zu testende Steuerungsprogramm und deren Ausführungsplattform untersucht, um die Programminterfaces zu detektieren und plattformspezifische Variablen zu nutzen. Das System kann sich somit automatisch auf verschiedene Programmumgebungen oder Ausführungsplattformen einstellen, sofern die entsprechende Syntax der Programmiersprache bzw. der Befehlsstrukturen bekannt ist.

Hierauf basierend wird automatisch ein Test-Harnisch generiert. Der Test-Harnisch stellt eine Kopie des Original-Programms mit hinzugefügten Anweisungen (im Prinzip sog. Debugging-Anweisungen) zur Ermöglichung der Eingabestimulation, der Aufzeichnung der Ausgabewerte und der Manipulation interner Signale dar.

Der Test-Harnisch wird sodann ausgeführt. Sobald vorgegebene Bedingungen erfüllt sind, wird die Ausführung angehalten, der aktuelle Stand der Programm-Variablen an das Testtool gesendet und die Signale basierend auf dem Zustand der Programm-Variablen erneut erzeugt und zurück an die Ausführungsplattform gesendet. Sofern es sich - wie bevorzugt - um Tests von Echtzeit-Signalverarbeitungen handelt, wird die Ausführungszeit für die Dauer der vorbeschriebenen Modifikation der Testumgebung bevorzugt angehalten, so dass der Testablauf durch den Eingriff des Testsystems zeitlich nicht verändert wird.

Ein entsprechendes Kriterium kann beispielsweise lauten:
*Wenn ["Bedingung"] während {"Zeit"} Sekunden dann ( "Kommandos zur Änderung der Eingabestimulationen")*

Als Bedingung kann jeder auswertbare logische Ausdruck verwendet werden, z.B. signal > 5. Die o.g. Pseudo-Programmiersprache ist darauf ausgelegt, dem Benutzer möglichst große Freiheiten für umgangssprachliche Definitionen zu gewähren, beispielsweise durch Verwendung alternativer Schlüsselwörter (z.B. kann statt "Wenn" für Bedingungskonstruktionen auch der Begriff "Falls" benutzt werden).

Die Spezifizierung der Zeit ist optional. Wenn diese vorhanden ist, wird die Bedingung für die vorgegebene Zeitdauer überprüft. Ohne Zeitangabe wird die Bedingung nur einmalig zu dem jeweiligen Zeitpunkt der Simulation überprüft.

Gemäß der nachfolgenden beispielhaften Spezifizierung wird die Bedingung einmalig nach 1 Sekunde überprüft.
*Warte für {1} Sekunde*
*Wenn ["Bedingung"] ( "Kommandos zur Änderung der Eingangs-Stimulationen')*

Wenn "Bedingung" nicht erfüllt ist, werden die Kommandos innerhalb des Wenn-Blocks nicht ausgeführt. Wenn "Bedingung" erfüllt ist, dauert die Ausführung des Bedingungsblocks so lange, wie für die Ausführung der Kommandos zur Änderung der Eingangs-Stimulationen benötigt werden.

Weiterhin ist es möglich, Programm-Variablen, für die Werte, die bei der Ausführung generiert werden, zu überschreiben bzw. abzuändern ("Überschreiben"). Dies ermöglicht dem Tester eine tiefergehende Interaktion mit dem zu testenden Steuerungsprogramm und den simulierten Werten, insbesondere im Hinblick auf die Überprüfung von Bedingungen. Beispielsweise kann auf ein bestimmtes Ereignis gewartet werden und dann durch Überschreiben der korrekten Werte mit bewusst falschen Werten eine Fehlfunktion simuliert werden. Damit kann beispielsweise ein Ausfall bestimmter Komponenten und Sensoren simuliert werden, und zwar dynamisch, beispielsweise während stark transienter Zustände des zu testenden Systems. Das Überschreiben von Werten kann bedingungsgesteuert auch jederzeit beendet werden:
*Überschreiben <signal1> ein*
*Überschreiben <signal1> aus*

Die reaktiven Aktionen können sowohl im Testabschnitt als auch bei den Akzeptanzkriterien zur Änderung der Simulationsparameter aber auch der Akzeptanzkriterien herangezogen werden, basierend auf den spezifizierten Bedingungen.

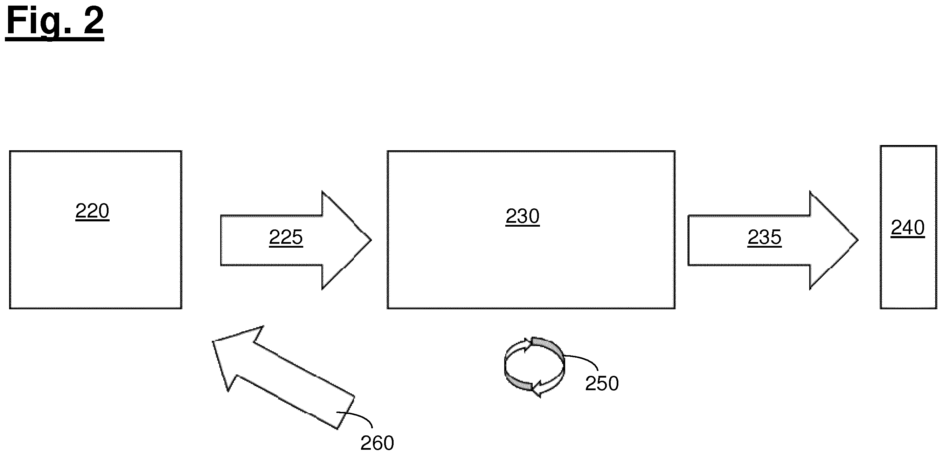

Figur 2 erläutert nochmals einen wesentlichen Aspekt des erfindungsgemäßen Testverfahrens, nämlich die dynamische Anpassung des Test-Harnischs. Das TestTool 220 gibt Signale 225 an das zu testende Steuerungsprogramm bzw. den Test-Harnisch 230. Während der Ausführung des Tests werden regelmäßig (bei jedem Zeitstempel) vorgegebene Bedingungen bei 250 überprüft und bei Erfüllung der Bedingungen eine erneute Generierung der Signale (Pfeil 260) ausgelöst. Die Ausgangssignale werden bei 235 in einen Datenspeicher 240 übertragen und dort zur Auswertung gespeichert.

Der Schritt der erneuten Generierung der Signale durch die Test-Applikation während des Tests kann verschieden implementiert werden, je nach Komplexität der Bedingungen. Etwa werden in dem vorhandenen Test-Harnisch bestimmte numerische Parameter angepasst oder bestimmte, bereits im Test-Harnisch vorhandene alternative Debugging-Blöcke ausgewählt. Durch die dynamische Anpassbarkeit des Tests kann der Testverlauf abhängig von der Reaktion des zu testenden Programms durchaus unterschiedlich ausfallen, was die Aussagekraft der Tests erhöht.

## Patentansprüche

1. Verfahren zum Testen elektronischer Steuerungen, insbesondere zum Testen von Automobilsteuerungen, wobei in einem Simulationsprozess ein vorgegebenes Szenario auf einer Testplattform in einem Testszenario simuliert wird und wobei die Testplattform in diesem Simulationsprozess auf Basis von Eingangs-Stimuli Ausgangswerte erzeugt, wobei
eine dynamische Anpassung des Testszenarios während des Simulationsprozesses auf Basis des aktuellen Zustandes des Simulationsprozesses erfolgt, indem die Ausführung des Simulationsprozesses unterbrochen wird, eine Kommunikation mit der Testplattform erfolgt, die Eingangs-Stimuli neu berechnet werden, die Eingangs-Stimuli dann an die Testplattform gesendet werden und ein Umschalten auf die neu berechneten Eingangs-Stimuli erfolgt, bevor die Simulation fortgesetzt wird, mit den Schritten
- Parsing und/oder Syntax- und Semantikanalyse (S125) einer Test-Fall-Spezifikation und Kompilierung (S130) zu Signalen;
- Automatisches Erzeugen (S135) eines Test-Harnisches (S140) als Kopie des ursprünglichen Steuerprogramms, ergänzt oder angereichert durch spezifische Elemente, welche die Eingabestimulation, die Aufzeichnung der Ausgangswerte und die Manipulation der internen Signale ermöglichen, einschließlich Elementen zum Unterbrechen der Ausführung des Tests, sobald entsprechende Bedingungen erfüllt sind;
- automatische Durchführung (S145, S150) des Tests; und
- Unterbrechen der Ausführung des Tests, sobald entsprechende Bedingungen erfüllt sind, und Senden des aktuellen Status der Programmvariablen an eine Vorrichtung, die Signale basierend auf dem Status der Softwarevariablen neu erzeugt und zurück an den Test-Harnisch (S140) sendet.

2. Verfahren nach Anspruch 1,
**dadurch gekennzeichnet, dass**
bei der Anpassung des Testszenarios Eingangs-Stimuli während des Simulationsprozesses in Abhängigkeit von den erzeugten Ausgangswerten geändert werden.

3. Verfahren nach Anspruch 1 oder 2,
**dadurch gekennzeichnet, dass**
bei der Anpassung des Testszenarios zumindest einige von der Testplattform erzeugte Ausgangswerte überschrieben werden.

4. Vorrichtung zum Testen elektronischer Steuerungen, insbesondere zum Testen von Automobilsteuerungen, wobei in einem Simulationsprozess ein vorgegebenes Szenario auf einer Testplattform in einem Testszenario simuliert wird und wobei die Testplattform in diesem Simulationsprozess auf Basis von Eingangs-Stimuli Ausgangswerte erzeugt,
**dadurch gekennzeichnet, dass**
die Vorrichtung dazu konfiguriert ist, ein Verfahren nach einem der vorhergehenden Ansprüche durchzuführen.

## Claims

1. Method for testing electronic controllers, in particular for testing automobile controllers, wherein a predefined scenario is simulated in a simulation process on a test platform in a test scenario, and wherein the test platform generates output values on the basis of input stimuli in this simulation process, wherein
the test scenario is dynamically adapted during the simulation process on the basis of the current state of the simulation process by interrupting the execution of the simulation process,
communication with the test platform is carried out, the input stimuli are newly calculated, the input stimuli are then transmitted to the test platform and a changeover to the newly calculated input stimuli is carried out before the simulation is continued, having the steps of
- parsing and/or syntax and semantic analysis (S125) of a test case specification and compilation (S130) to form signals;
- automatically generating (S135) a test harness (S140) as a copy of the original control program, supplemented or enriched with specific elements which enable the input stimulation, the recording of the output values and the manipulation of the internal signals, including elements for interrupting the execution of the test as soon as corresponding conditions are satisfied;
- automatically carrying out (S145, S150) the test; and
- interrupting the execution of the test as soon as corresponding conditions are satisfied, and transmitting the current status of the program variables to an apparatus which newly generates signals on the basis of the status of the software variables and transmits them back to the test harness (S140).

2. Method according to Claim 1,
**characterized in that**
when adapting the test scenario, input stimuli are changed during the simulation process on the basis of the generated output values.

3. Method according to Claim 1 or 2,
**characterized in that**
when adapting the test scenario, at least some output values generated by the test platform are overwritten.

4. Apparatus for testing electronic controllers, in particular for testing automobile controllers, wherein a predefined scenario is simulated in a simulation process on a test platform in a test scenario, and wherein the test platform generates output values on the basis of input stimuli in this simulation process,
**characterized in that**
the apparatus is configured to carry out a method according to one of the preceding claims.

## Revendications

1. Procédé pour soumettre à essai des commandes électroniques, notamment pour soumettre à essai des commandes d'automobile, un scénario prédéfini étant simulé lors d'un processus de simulation sur une plate-forme d'essai dans un scénario d'essai et la plate-forme d'essai générant, dans ce processus de simulation, des valeurs de sortie sur la base de stimuli d'entrée,
une adaptation dynamique du scénario d'essai ayant lieu pendant le processus de simulation sur la base de l'état actuel du processus de simulation en interrompant l'exécution du processus de simulation, en effectuant une communication avec la plate-forme d'essai, en recalculant les stimuli d'entrée, en envoyant ensuite les stimuli d'entrée à la plate-forme d'essai et en effectuant une permutation sur les stimuli d'entrée nouvellement calculés avant de poursuivre la simulation, le procédé comprenant les étapes suivantes
- analyse syntaxique et/ou analyse syntaxique et sémantique (S125) d'une spécification d'essai élémentaire et compilation (S130) en des signaux ;
- génération automatique (S135) d'un harnais d'essai (S140) en tant que copie du programme de commande originel, complété ou enrichi par des éléments spéciaux qui rendent possible la stimulation de saisie, l'enregistrement des valeurs de sortie et la manipulation des signaux internes, y compris des éléments servant à interrompre l'exécution de l'essai dès que des conditions correspondantes sont remplies ;
- réalisation automatique (S145, S150) de l'essai ; et
- interruption de l'exécution de l'essai dès que des conditions correspondantes sont remplies, et envoi de l'état actuel des variables de programme à un dispositif qui génère de nouveau les signaux en se basant sur l'état des variables de programme et les renvoie au harnais d'essai (S140).

2. Procédé selon la revendication 1, **caractérisé en ce que** lors de l'adaptation du scénario d'essai, les stimuli d'entrée sont modifiés pendant le processus de simulation en fonction des valeurs de sortie générées.

3. Procédé selon la revendication 1 ou 2, **caractérisé en ce que** lors de l'adaptation du scénario d'essai, au moins certaines des valeurs de sortie générées par la plate-forme d'essai sont remplacées.

4. Dispositif pour soumettre à essai des commandes électroniques, notamment pour soumettre à essai des commandes d'automobile, un scénario prédéfini étant simulé lors d'un processus de simulation sur une plate-forme d'essai dans un scénario d'essai et la plate-forme d'essai générant, dans ce processus de simulation, des valeurs de sortie sur la base de stimuli d'entrée,
**caractérisé en ce que**
le dispositif est configuré pour mettre en oeuvre un procédé selon l'une des revendications précédentes.
